# EUROPEAN PATENT APPLICATION

(11) **EP 3 651 205 A1**
(43) Date of publication of application: **13.05.2020**
(21) Application number: 18204904.9
(22) Date of filing: 07.11.2018
(51) Int. Cl.: H01L 29/778, H01L 29/06, H01L 29/417, H01L 29/10, H01L 29/40, H01L 29/20

(54) **SEMICONDUCTOR DEVICE AND METHOD**

(71) Applicant: Infineon Technologies Austria AG, 9500 Villach (AT)
(72) Inventor: PRECHTL, Gerhard, 9232 Rosegg (AT); CURATOLA, Gilberto, 9500 Villach (AT); HAEBERLEN, Oliver, A-9524 St. Magdalen (AT)
(74) Representative: Moore, Joanne Camilla

(57) **Abstract**

In an embodiment, semiconductor device comprises a Group III nitride-based transistor comprising a Group III nitride channel layer (12), a Group III nitride barrier layer (13) on the Group III nitride channel layer, the Group III nitride barrier layer and the Group III nitride channel layer having differing bandgaps and forming a heterojunction (14) capable of supporting a two dimensional electron gas, wherein the Group III nitride barrier layer has a major surface (18), a source electrode (19), a gate electrode (20) and a drain electrode (21) arranged on the major surface of the Group III nitride barrier layer, the gate electrode being arranged between the source electrode and the drain electrode, and a plurality of discrete p-doped regions (22) arranged on the major surface of the Group III nitride barrier layer and arranged on a drain side of the gate electrode and laterally spaced apart from the gate electrode, the plurality of discrete p-doped regions being electrically coupled to the drain electrode.

## Description

### BACKGROUND

To date, transistors used in power electronic applications have typically been fabricated with silicon (Si) semiconductor materials. Common transistor devices for power applications include Si CoolMOS®, Si Power MOSFETs, and Si Insulated Gate Bipolar Transistors (IGBTs). More recently, silicon carbide (SiC) power devices have been considered. Group III-N semiconductor devices, such as gallium nitride (GaN) devices, are now emerging as attractive candidates to carry large currents, support high voltages and to provide very low on-resistance and fast switching times.

An issue in the GaN HEMT technology is the existence of deep traps which can lead to unwanted dynamic effects such as current collapse and dynamic RDSON increase at fast switching. Further developments to mitigate or eliminate these effects are desirable.

### SUMMARY

In an embodiment, semiconductor device comprises a Group III nitride-based transistor comprising a Group III nitride channel layer, a Group III nitride barrier layer on the Group III nitride channel layer, the Group III nitride barrier layer and the Group III nitride channel layer having differing bandgaps and forming a heterojunction capable of supporting a two dimensional electron gas, wherein the Group III nitride barrier layer has a major surface, a source electrode, a gate electrode and a drain electrode arranged on the major surface of the Group III nitride barrier layer, the gate electrode being arranged between the source electrode and the drain electrode, and a plurality of discrete p-doped regions arranged on the major surface of the Group III nitride barrier layer and arranged on a drain side of the gate electrode and laterally spaced apart from the gate electrode, the plurality of discrete p-doped regions being electrically coupled to the drain electrode.

In an embodiment, a semiconductor device comprises a Group III nitride-based transistor comprising a Group III nitride channel layer, a Group III nitride barrier layer on the Group III nitride channel layer, the Group III nitride barrier layer and the Group III nitride channel layer having differing bandgaps and forming a heterojunction capable of supporting a two dimensional electron gas, wherein the Group III nitride barrier layer has a major surface, a source electrode, a gate electrode and a drain electrode arranged on the major surface of the Group III nitride barrier layer, the gate electrode being arranged between the source electrode and the drain electrode, and a single p-doped region arranged on the major surface of the Group III nitride barrier layer and electrically coupled to the drain electrode. The drain electrode is arranged laterally between the p-doped region and the gate electrode.

In an embodiment, a method comprises forming a plurality of discrete p-doped regions on a barrier layer of a Group III nitride-based transistor, the Group III nitride barrier layer being arranged on a Group III nitride channel layer, the Group III nitride barrier layer and the Group III nitride channel layer having differing bandgaps and forming a heterojunction capable of supporting a two dimensional electron gas, forming a source electrode, a gate electrode and a drain electrode on the barrier layer, the gate electrode being arranged between the source electrode and the drain electrode such that the plurality of discrete p-doped regions are arranged on a drain side of the gate electrode and laterally spaced apart from the gate electrode and electrically coupling the plurality of discrete p-doped regions to the drain electrode.

Those skilled in the art will recognize additional features and advantages upon reading the following detailed description, and upon viewing the accompanying drawings.

### BRIEF DESCRIPTION

The elements of the drawings are not necessarily to scale relative to each other. Like reference numerals designate corresponding similar parts. The features of the various illustrated embodiments can be combined unless they exclude each other. Exemplary embodiments are depicted in the drawings and are detailed in the description which follows.
Figure 1, which includes figures 1A to 1C, illustrates a top view and two cross-sectional views of a Group III nitride-based transistor according to an embodiment.
Figure 2, which includes figures 2A to 2C, illustrates a top view and two cross-sectional views of the Group III nitride-based transistor according to an embodiment.
Figure 3 illustrates a top view of a Group III nitride-based transistor including hole injectors having a first contour.
Figure 4 illustrates a top view of a Group III nitride-based transistor including hole injectors having a second contour.
Figure 5 illustrates a top view of the Group III nitride-based transistor including hole injectors having third contour.
Figure 6, which includes figures 6A to 6C, illustrates a top view and two cross-sectional views of a Group III nitride-based transistor including a field plate according to an embodiment.
Figure 7, which includes figures 7A to 7C, illustrates a top view and two cross-sectional views of a Group III nitride-based transistor including a field plate according to an embodiment.
Figure 8, which includes figures 8A to 8C, illustrates a top view and two cross-sectional views of a Group III nitride-based transistor according to an embodiment.
Figure 9, which includes figures 9A and 9B, illustrates a top view and a cross-sectional view of a Group III nitride-based transistor according to an embodiment.
Figure 10 illustrates a flow chart of a method for fabricating a Group III nitride-based transistor.
Figure 11 illustrates the function of a Group III nitride-based transistor according to embodiments described herein.

### DETAILED DESCRIPTION

In the following detailed description, reference is made to the accompanying drawings, which form a part hereof, and in which is shown by way of illustration specific embodiments in which the invention may be practiced. In this regard, directional terminology, such as "top", "bottom", "front", "back", "leading", "trailing", etc., is used with reference to the orientation of the figure(s) being described. Because components of the embodiments can be positioned in a number of different orientations, the directional terminology is used for purposes of illustration and is in no way limiting. It is to be understood that other embodiments may be utilized and structural or logical changes may be made without departing from the scope of the present invention. The following detailed description, thereof, is not to be taken in a limiting sense, and the scope of the present invention is defined by the appended claims.

A number of exemplary embodiments will be explained below. In this case, identical structural features are identified by identical or similar reference symbols in the figures. In the context of the present description, "lateral" or "lateral direction" should be understood to mean a direction or extent that runs generally parallel to the lateral extent of a semiconductor material or semiconductor carrier. The lateral direction thus extends generally parallel to these surfaces or sides. In contrast thereto, the term "vertical" or "vertical direction" is understood to mean a direction that runs generally perpendicular to these surfaces or sides and thus to the lateral direction. The vertical direction therefore runs in the thickness direction of the semiconductor material or semiconductor carrier.

As employed in this specification, when an element such as a layer, region or substrate is referred to as being "on" or extending "onto" another element, it can be directly on or extend directly onto the other element or intervening elements may also be present. In contrast, when an element is referred to as being "directly on" or extending "directly onto" another element, there are no intervening elements present.

As employed in this specification, when an element is referred to as being "connected" or "coupled" to another element, it can be directly connected or coupled to the other element or intervening elements may be present. In contrast, when an element is referred to as being "directly connected" or "directly coupled" to another element, there are no intervening elements present.

A depletion-mode device, such as a high-voltage depletion-mode transistor, has a negative threshold voltage which means that it can conduct current at zero gate voltage. These devices are normally on. An enhancement-mode device, such as a low-voltage enhancement-mode transistor, has a positive threshold voltage which means that it cannot conduct current at zero gate voltage and is normally off. An enhancement-mode device is not limited to low voltages and may also be a high-voltage device.

As used herein, the phrase "Group III-Nitride" refers to a compound semiconductor that includes nitrogen (N) and at least one Group III element, including aluminum (Al), gallium (Ga), indium (In), and boron (B), and including but not limited to any of its alloys, such as aluminum gallium nitride (AlₓGa₍₁₋ₓ₎N), indium gallium nitride (In_{y}Ga_{(1-y)}N), aluminum indium gallium nitride (AlₓIn_{y}Ga_{(1-x-y)}N), gallium arsenide phosphide nitride (GaAsₐP_{b}N_{(1-a-b)}), and aluminum indium gallium arsenide phosphide nitride (AlₓIn_{y}Ga_{(1-x-y)}AsₐPbN_{(1-a-b)}), for example. Aluminum gallium nitride and AlGaN refer to an alloy described by the formula AlₓGa₍₁₋ₓ₎N, where 0 < x < 1.

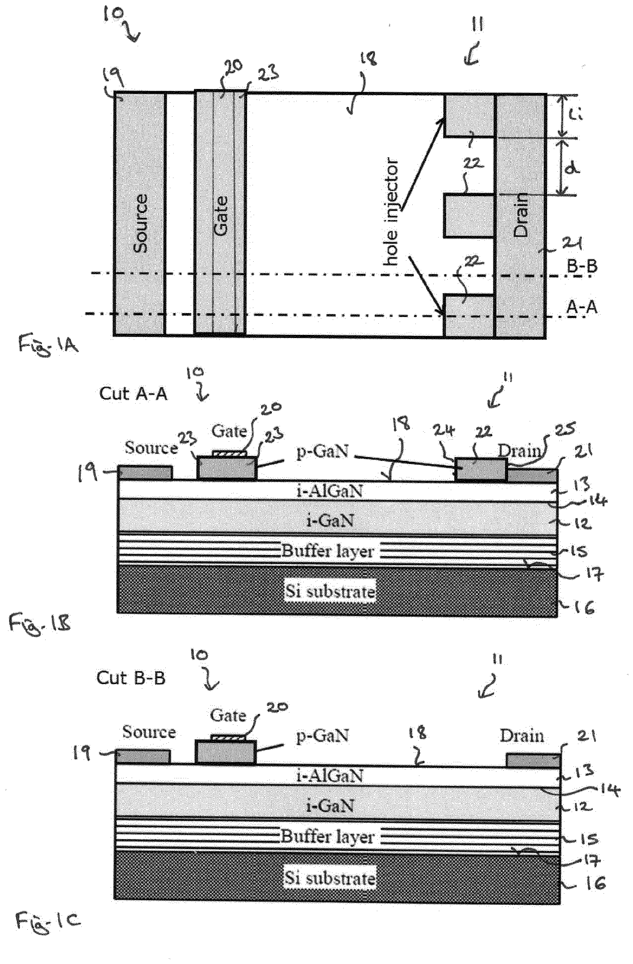

Figure 1, which includes figures 1A to 1C, illustrates a semiconductor device 10 according to an embodiment which comprises a Group III nitride-based transistor 11. Figure A illustrates a top view, figure 1B a cross-sectional view along the line A-A and figure 1C cross-sectional view along the line B-B of the Group III nitride-based transistor 11.

As can be seen in the cross-sectional views of figures 1B and 1C, the Group III nitride-based transistor 11 includes a Group III nitride channel layer 12 and a Group III nitride barrier layer 13 which is arranged on the Group III nitride channel layer. The Group III nitride-based channel layer 12 Group III nitride-based barrier layer 13 have different bandgaps and form a heterojunction 14 which is capable of supporting a two dimensional electron gas (2DEG). The channel layer 12 may be arranged on a buffer layer 15 which is in turn arranged on a substrate 16.

The substrate 16 may be a silicon substrate but in other embodiments may include other materials such as sapphire substrate. The substrate 16 has a first surface 17 which is capable of supporting the epitaxial growth of Group III nitride materials. The buffer layer 15 may include a buffer structure comprising a Group III nitride materials.

A typical buffer structure for a silicon substrate includes a AlN starting layer, which may have a thickness of several 100nm, on the silicon substrate followed by a AlₓGa₍₁₋ₓ₎N layer sequence, the thickness again being several 100nm's for each layer, whereby the Al content of about 50-75% is decreased down to 10-25% before the GaN layer or AlGaN back barrier is grown. Alternatively a superlattice buffer can be used. Again an AlN starting layer on the silicon substrate is used. Depending on the chosen superlattice, a sequence of AlN and AlₓGa₍₁₋ₓ₎N pairs is grown, where the thickness of the AlN layer and AlₓGa₍₁₋ₓ₎N is in the range of 5-15nm. Depending on the desired breakdown voltage the superlattice may include between 20 and 100 pairs. Alternatively, an AlₓGa₍₁₋ₓ₎N layer sequence as described above can be used in combination with the above-mentioned super lattice. In some embodiments, the buffer structure, or some or all of the layers of the buffer structures mentioned above are Carbon doped.

The Group III nitride channel layer 12 may comprise gallium nitride (GaN) which may be intrinsically doped. The barrier layer 13 may include aluminium gallium nitride (AlGaN) which may be intrinsically doped. The Group III nitride barrier layer 13 has a first major surface 18 on which a source electrode 19, a gate electrode 20 and a drain electrode 21 are arranged. The gate electrode 20 is arranged laterally between the source electrode 19 and the drain electrode 20. The Group III nitride barrier layer 13 has a thickness which is uniform between the source electrode 19 and drain electrode 21. The Group III nitride transistor 11 may be considered to have a single barrier structure.

As can be seen in the top view of figure 1A, the source electrode 19, the gate electrode 20 and the drain electrode 21 may each have an elongate strip-like form and extend substantially parallel to one another. The spacing between the source electrode 19 and the gate electrode 20 may be less than the spacing between the gate electrode 20 and the drain electrode 21.

The Group III nitride-based transistor 11 further includes a plurality of hole injectors. Each of the hole injectors may be provided by a discrete p-doped region 22 arranged on the major surface 18 of the Group III nitride barrier layer 13. The p-doped regions 22 are arranged on a drain side of the gate electrode 20 and are laterally spaced apart from the gate electrode 20. The plurality of discrete p-doped regions 22 is electrically coupled to the drain electrode 21.

The discrete p-doped regions 22 may be arranged in a row that extends substantially parallel to the length of the drain electrode 21, the gate electrode 20 and the source electrode 19.

The plurality of discrete p-doped regions 22 are spaced apart from another by intervening regions of the first major surface 18 of the Group III nitride barrier layer 13. Each of the p-doped discrete p-doped regions 22 has a defined area and may have the form of an island having a thickness defined by sidewalls having a height h. In some embodiments, each discrete p-doped region has a length lᵢ and a spacing d from the nearest adjacent discrete p-doped region, wherein d ≤ lᵢ ≤ 1000d.

The plurality of discrete p-doped regions 22 may be electrically coupled to the drain electrode 21 in a number of ways. For example, the drain electrode 21 may be physically and electrically in contact with the discrete p-doped regions 22. The discrete p-doped regions 22 may, however, be laterally spaced apart from the drain electrode 21 and be electrically connected to the drain electrode 21 by an additional connector, such as a bond wire, contact clip or ribbon, or by a power metallization structure formed on the major surface 18 of the Group III nitride barrier layer 13.

The cross-sectional view of figure 1B illustrates a cross-section through the Group III nitride transistor 11 which is positioned on, and cuts through, one of the p-doped regions 22. The cross-sectional view of figure 1C long the line B-B is positioned between two p-doped regions 22 such that at this lateral position of the Group III nitride-based transistor 11, no p-doped region is positioned in a line of sight between the gate electrode 20 and the drain electrode 21, the line of sight extending perpendicularly to the length of the gate electrode 20 and drain electrode 21. In contrast, the p-doped region 22 seen in the cross-sectional view of figure 1B, along the line A-A, is in a direct line of sight between the gate electrode 20 and the drain electrode 21, the line of sight extending perpendicularly to the length of the gate electrode 20 and drain electrode 21.

The plurality of p-doped regions 22 are provided in order to provide a laterally limited and localised depletion of the two-dimensional electron gas formed at the heterojunction 14. This depletion of the two-dimensional electron gas formed at the heterojunction 14 is laterally localised at a position underneath each of the discrete p-doped regions 22. The p-doped regions 22 are shifting the conduction bands in such a way that the 2DEG is completely or partially depleted. This effect is similar to a standard pGaN Gate transistor where the 2DEG is depleted underneath of the pGaN gate. The internal build in voltage of the pGaN-2DEG diode of about 3V may deplete a 2DEG below the gate region or in this case below the p-GaN region at the drain side. Additionally, the pGaN drain can inject holes (under certain bias conditions) into deep traps in the Group III nitride barrier layer 13 so that each region 22 can be considered to be a hole injector. The Group III nitride barrier layer 13 has a thickness such that this laterally localised depletion of the two-dimensional electron gas below the individual discrete p-doped regions can be achieved.

Each of the p-doped regions 22 may comprise a p-doped Group III nitride. The p-doped Group III nitride may be gallium nitride doped with magnesium. In other embodiments, the p-doped Group III nitride may comprise aluminium gallium nitride which is doped with magnesium.

In some embodiments, such as that illustrated in figure 1, the plurality of discrete p-doped regions 22 are laterally arranged between the gate electrode 20 and the drain electrode 21, as illustrated in figures 1A and 1B. The individual discrete p-doped regions 22 may be considered to have a gate facing end 24 and a drain facing and 25 which opposes the gate facing end 24. The drain facing end 25 may be spaced apart from the drain electrode 21 or may be in direct physical contact with the drain electrode 21.

The hole injector structure provided by the discrete p-doped regions 22, which are electrically coupled to the drain electrode 21, is separate from any gate structure provided to provide an enhancement mode Group III nitride-based transistor, which is normally off.

For example, as illustrated in figure 1, the Group III nitride-based transistor 11 may include a gate injector structure and be a gate injector transistor (GIT) in which the gate structure includes a p-doped Group III nitride-based layer 23 positioned between the metal gate electrode 20 and the Group III nitride barrier layer 13. The Group III barrier layer 13 has a substantially constant thickness throughout the region from the source 19 to the drain electrode 21 including under the gate electrode 20. The p-doped Group III nitride region 23 has the form of an elongate strip which extends continuously under the gate electrode 20 and has a length that extends substantially parallel to the length of the source electrode 19 and of the drain electrode 21. The p-doped Group III nitride region 23 is spaced apart from the source electrode 19 and from the p-doped regions 22 and the drain electrode 21. In embodiments in which the p-doped regions 22 include a p-doped Group III nitride, the p-doped Group III nitride region 23 under the gate and the discrete p-doped regions 22 may be fabricated using the same process steps.

In some embodiments, the discrete p-doped regions 22 are arranged in a row which extends substantially parallel to the drain electrode 21, as illustrated in figure 1A. The row of discrete p-doped regions may be laterally arranged between the gate-facing side face of the drain electrode 21 and the drain facing side face of the gate electrode 20. The drain-facing side face of the p-doped regions 22 may be in physical contact with or laterally spaced apart from the gate-facing side face of the drain electrode 21. In some embodiments, the discrete p-doped regions may be interleaved with sections 26 of the drain electrode 21.

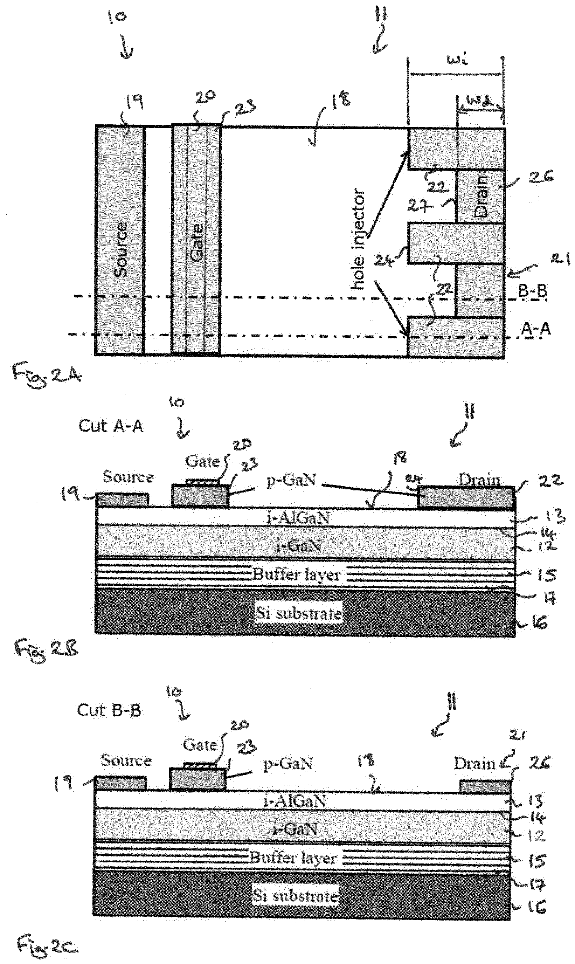

In some embodiments, as is illustrated in figure 2, the plurality of p-doped regions 22 that are interleaved with sections 26 of the drain electrode 21, whereby figure 2A illustrates a plan view, figure 2B illustrates a cross-sectional view along the line A-A through one of the discrete p-doped regions 22 and figure 2C illustrates a cross-sectional view along the line B-B through a section 26 of the drain electrode 22 of the Group III nitride-based transistor 11'.

In these embodiments, the drain electrode 21 includes a plurality of portions 26 which are spaced apart from one another and arranged in a row which extends substantially parallel to the gate electrode 20 and the source electrode 19. The individual p-doped regions 22 are interleaved with the portions 26 of the drain electrode 21 so that the neighbouring discrete p-doped regions 22 are spaced apart from one another by a section 26 of the drain electrode 21.

In some embodiments, the width wᵢ of the p-doped regions 22 is substantially the same as the width w_{d} of the portions 26 of the drain electrode 21. In other embodiments, such as that illustrated in figure 2, the individual discrete p-doped regions 22 have a width wᵢ which is greater than the width w_{d} of the drain electrode 21 such that the gate-facing side face or gate-side end 24 of the p-doped regions 22 is laterally positioned closer to the gate 20 than the gate-facing side face 27 of the drain electrode 21. The discrete p-doped regions 22 can be considered to laterally protrude from the drain electrode 21. In embodiments in which the discrete p-doped regions 22 are interleaved with sections 26 of the drain electrode 21, the discrete p-doped regions 22 may be in physical contact with adjacent sections 26 of the drain electrode 21 or may be spaced apart from the sections 26 of the drain electrode 21. In some embodiments, the width wᵢ of the p-doped regions 22 is less than the width w_{d} of the portions 26 of the drain electrode 21. The lateral spacing between the p-doped regions 22 and the gate 20 is greater than the lateral spacing between the drain electrode 21 and the gate 20 in these embodiments. In some embodiments, the p-doped regions 22 may be positioned laterally within and be entirely surrounded by the drain electrode 21.

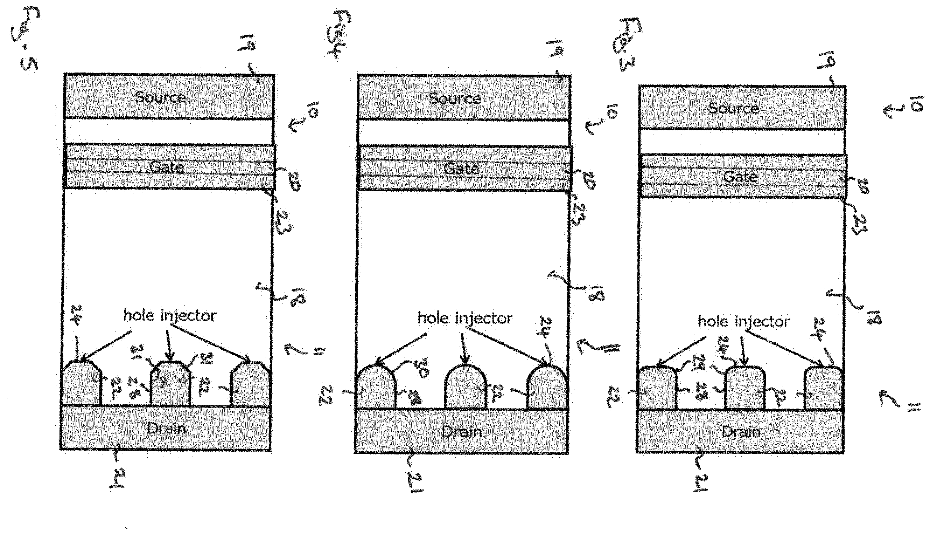

In figures 1 and 2, the individual discrete p-doped regions 22 are illustrated as having a square or rectangular form or contour in plan view. However, the discrete p-doped regions 22 may have other contours in plan view. In particular, the gate-side end 24 of the discrete p-doped regions 22 may have a rounded form. Figures 3 to 5 illustrate three different embodiments in which the gate facing end 22 of the discrete p-doped regions 22 has a different rounded contour.

In figure 3, the discrete p-doped regions 22 have a substantially square or rectangular form in plan view with the corners 29 between the gate-facing end 24 and the horizontal side faces 28 being rounded. In other words, the corner has a radius. Figure 4 illustrates another embodiment in which the gate-facing end 24 has a substantially curved form 30 and may be semicircular. In figure 5, the corners between the gate-facing end 24 and horizontal side faces 28 include a chamfer 31 so that the internal angle, a, formed between the horizontal side face 28 and the chamfer 31 is greater than 90°. The gate-facing end 24 may include a plurality of facets or chamfers including more than the three facets illustrated in figure 5 to produce a contour with less sharp edges than the rectangular form of Figures 1 and 2.

In figures 3 to 5, the p-doped regions 22 are positioned laterally between the gate 20 and the drain electrode 21 with the drain-facing end 25 in contact with the drain electrode 21. However, the contours illustrated in figures 3 to 5 for the gate-facing and 24 of the p-doped regions 22 may also be used in embodiments in which the discrete p-doped regions 22 are laterally spaced apart from the drain electrode 21 and/or are interleaved with sections of the drain electrode 21, as in the embodiment illustrated in figure 2.

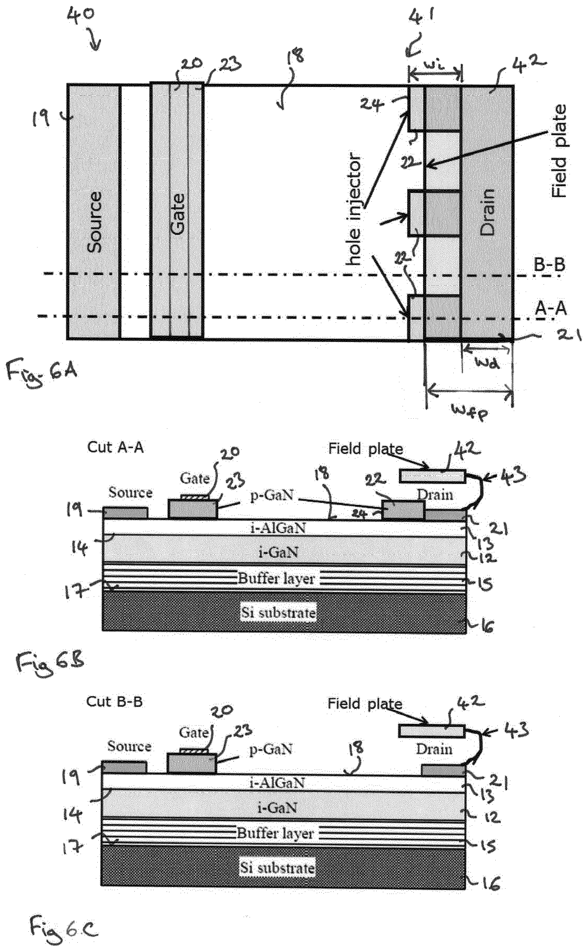

Figure 6 illustrates a semiconductor device 40 including a Group III nitride-based transistor 41 according to an embodiment. Figure 6A illustrates a top view, figure 6B illustrates a cross-sectional view along the line A-A and figure 6C a cross-sectional view along the line B-B. The Group III nitride-based transistor 41 includes the features of the Group III nitride-based transistor 11 illustrated in figure 1 and additionally includes a field plate 42 which is electrically coupled to the drain electrode 21, as is indicated schematically by the line 43, and laterally spaced apart from the gate electrode 20.

The field plate 42 is positioned above the drain electrode 21 and has an elongate strip-like form that extends substantially parallel to the drain electrode 21. The field plate 42 has a width w_{fp} such that it extends over the entire width w_{d} of the drain electrode 21 and extends partially over the p-doped regions 22. The gate facing end 24 and the adjoining portion of the p-doped regions 22 remain uncovered by the field plate 42 in this embodiment. The field plate 42 may include a metallic layer which is positioned on the drain electrode 21 and plurality of p-doped regions 22 in order to electrically couple the field plate 42 to the drain electrode 21. The field plate 42 may be electrically coupled to the drain electrode 22 but physically separated from the p-doped regions 22, for example, by an insulating layer. The field plate 42 may be physically separate from the drain electrode 21, for example, an intervening insulating layer or layers may be arranged between a metal layer providing the field plate 42 and the metal layer providing the drain electrode 21. The field plate 42 may electrically coupled to the drain electrode 21 by one or more additional electrical connectors, for example a conductive via.

Whilst the p-doped regions 22 are illustrated in figure 6 is having the form same contour as the p-doped regions 22 of figure 1, the p-doped regions 22 of the Group III nitride-based transistor 41 are not limited to this contour but may also have the arrangement disclosed in connection with figure 2 and may, therefore, be interleaved with sections 26 of the drain electrode 21 and/or may have a gate facing end 24 having rounded contour, for example have the form of the p-doped regions illustrated in figures 3 to 5.

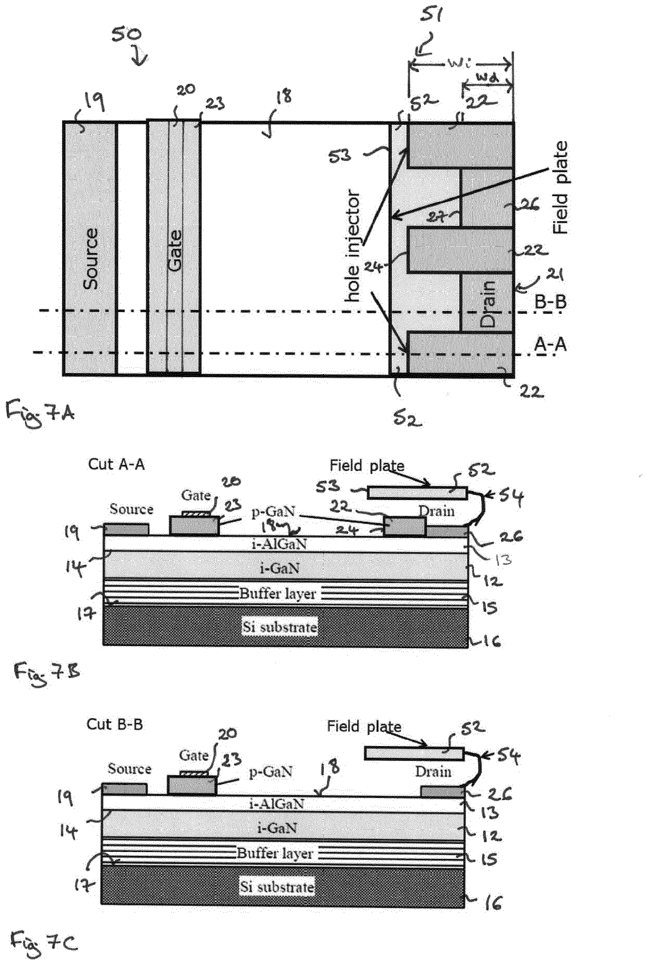

Figure 7 illustrates a semiconductor device 50 including a Group III nitride-based transistor 51 and a field plate 52. Figure 7A illustrates a top view, figure 7B illustrates a cross-sectional view along the line A-A and figure 7C a cross-sectional view along the line B-B of the semiconductor device 50. The Group III nitride-based transistor 51 has the form illustrated in figure 2 in which the p-doped regions 22 are interleaved with sections 26 of the drain electrode 21, whereby the p-doped regions 22 may have a greater width wᵢ than the width w_{d} of the drain electrode 21 and therefore be spaced at a smaller distance from the gate electrode 21 compared to the sections 26 of the drain electrode 21. The field plate 52 differs from the field plate 42 illustrated in figure 6 in that it extends over the entirety of the p-doped regions 22 such that it has a gate facing end 53 which is spaced at a smaller distance from the drain facing side of the gate electrode 20 compared to the gate facing end 24, 27 of both the p-doped regions 22 and the sections 26 of the drain electrode 21, respectively.

The field plate 52 is electrically coupled to the drain electrode 21, as is indicated by the schematically by the line 54, and laterally spaced apart from the gate electrode 20. The field plate 52 may be in direct contact with the drain electrode 21 and the p-doped regions 22 may have the form of a conductive layer which is deposited on the drain electrode 21 and p-doped layer p-doped regions 22. The field plate 52 may be vertically spaced apart from the p-doped regions 22 and drain electrodes 21 by an additional insulating layer or layers and be electrically connected to the sections 26 of the drain electrode 21 by conductive vias which extends through the intervening insulating layer or layers.

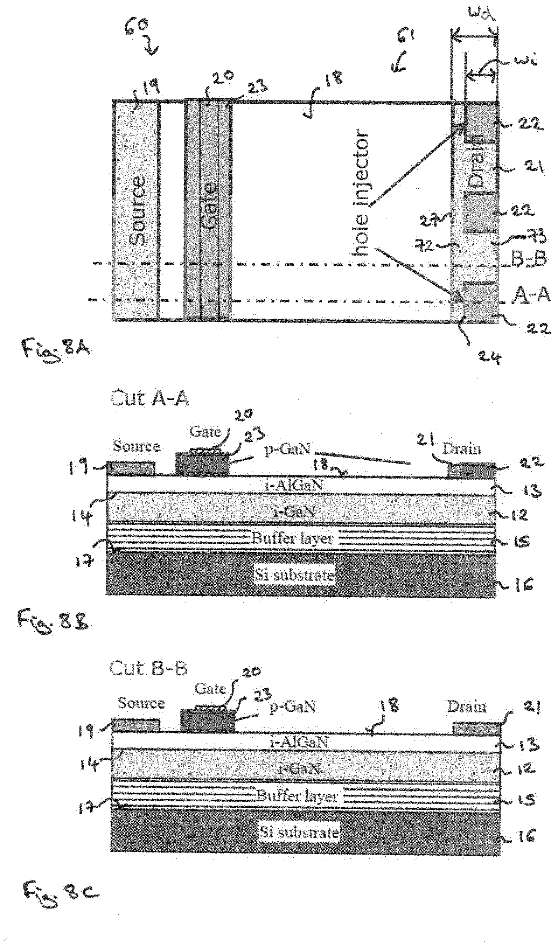

Figure 8, which includes figures 8A to 8C, illustrates a top view and two cross-sectional views of a semiconductor device 60 including a Group III nitride-based transistor 61 according to an embodiment. Figure 8A illustrates a top view, figure 8B a cross-sectional view along the line A-A and figure 8C a cross-sectional view along the line B-B of the semiconductor device 60.

The Group III nitride-based transistor 61 includes the features of the Group III nitride-based transistor 11 illustrated in figure 1. In this embodiment, the p-doped regions 22 have a width wᵢ that is less than the width w_{d} of the drain electrode 21. The gate facing ends 24 of the p-doped regions 22 are laterally spaced at a greater distance from the gate electrode 21 compared to the gate-facing side face 27 of the drain electrode 21.

In the semiconductor device 60, the gate facing ends and the p-doped regions 22 are surrounded by the drain electrode 21. The p-doped regions 22 are positioned within the drain electrode 21 so that the drain electrode 21 is interrupted by the p-doped regions 22. The drain electrode 21, therefore, has an uninterrupted portion 72 and a portion 73 that is interrupted by the p-doped regions 22. The uninterrupted portion 72 is positioned nearer to the gate 21 than the interrupted portion 73.

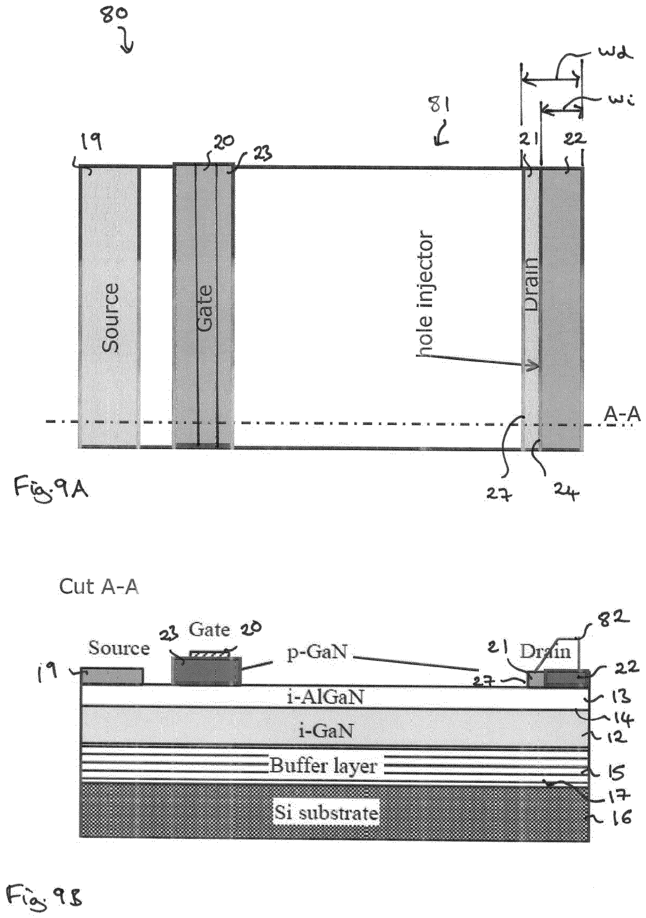

Figure 9, which includes figures 9A and 9B, illustrates a top view and a cross-sectional view of a semiconductor device 70 which includes a Group III nitride-based transistor 71 according to an embodiment.

The Group III nitride-based transistor 71 includes the features of the Group III nitride-based transistor 11 illustrated in figure 1. In this embodiment, the drain electrode 21 is arranged laterally between the p-doped region 22 and the gate electrode 20.

A single p-doped region 22 is provided that extends continuously and uninterruptedly adjacent to the entire length of the gate electrode 20. The single p-doped region 22 has a length such that it extends substantially parallel to the entire length of the gate electrode 20 and the drain electrode 21. also extends substantially parallel to the entire length of the gate electrode 20. The drain electrode 21 is continuous and uninterrupted in regions laterally adjacent the entire length of the gate electrode 20. The drain electrode 21 is laterally positioned between the gate electrode 20 and the p-doped region 22. In some embodiments, the drain electrode 21 is positioned entirely between the gate electrode 20 and the p-doped region 22.

In some embodiments, the drain electrode 21 is positioned partially between the gate electrode 20 and the p-doped region 22, for example a portion of the drain electrode 21 may be arranged on the p-doped region and a portion arranged adjacent to the p-doped region and laterally between the p-doped region 22 and the gate electrode 20.

The p-doped region 22 may have a width wᵢ that is less than the width w_{d} of the drain electrode 21. The gate-facing side face 27 of the drain electrode 21 is positioned nearer to the gate electrode 20 than the gate facing end 24 of the p-doped region 22 so that the gate facing end 24 of the p-doped region 22 is laterally spaced at a greater distance from the gate electrode 20 than the gate-facing side face 27 of the drain electrode 21.

The drain electrode 21 may be electrically coupled to the p-doped region 22 by an additional connector, such as a bond wire, contact clip or ribbon, or by a power metallization structure formed on the major surface 18 of the Group III nitride barrier layer 13. The electrical connection is illustrated schematically in Figure 9B by the line 82. In some embodiments, the drain electrode 21 may be in direct physical contact with and electrically connected to the p-doped region 22.

In the semiconductor device 60, the gate facing end 24 of the p-doped region 22 is surrounded by the drain electrode 21. The p-doped region 22 is positioned laterally adjacent the drain electrode 21 so that at least a portion of the uninterrupted drain electrode 21 is positioned nearer to the gate electrode 20 than the p-doped region 22 at all positions for the entire length of the gate electrode 20.

The channel formed between the gate electrode 20 and the drain electrode 21 is undepleted due to the absence of a p-doped region positioned laterally between the gate electrode 20 and the drain electrode 21. The p-doped region 22 is positioned adjacent the drain electrode on a side face of the drain electrode 21 that faces away from the gate electrode 20 so that the p-doped region 22 is positioned laterally adjacent and not vertically above the channel. However, the p-doped region 22 is able to act as a hole injector and inject sufficient holes into the channel formed between the gate electrode 20 and drain electrode 21 so that a reduction in dynamic RDSON effects are achieved. A single uninterrupted p-doped region 22 that is positioned laterally adjacent and not vertically above the channel enables the number of holes that can be injected into the channel to be increased to a level such that dynamic RDSon effects can be reduced.

In an embodiment, a semiconductor device comprises a Group III nitride-based transistor comprising a Group III nitride channel layer, a Group III nitride barrier layer on the Group III nitride channel layer, the Group III nitride barrier layer and the Group III nitride channel layer having differing bandgaps and forming a heterojunction capable of supporting a two dimensional electron gas, wherein the Group III nitride barrier layer has a major surface, a source electrode, a gate electrode and a drain electrode arranged on the major surface of the Group III nitride barrier layer, the gate electrode being arranged between the source electrode and the drain electrode, and a single p-doped region arranged on the major surface of the Group III nitride barrier layer and electrically coupled to the drain electrode. The drain electrode is arranged laterally between the p-doped region and the gate electrode.

In some embodiments, the single p-doped region is arranged laterally adjacent a channel of the Group III nitride-based transistor.

In some embodiments, the Group III nitride barrier layer has a thickness such that the single p-doped region produces a laterally localised depletion of the two dimensional electron.

In some embodiments, the single p-doped region comprises a p-doped Group III nitride.

In some embodiments, the single p-doped region and the drain electrode extend substantially parallel to the gate electrode and along an entire length of the gate electrode.

In some embodiments, the single p-doped region is in direct contact with the drain electrode, or is laterally spaced apart from the drain electrode.

In some embodiments, the semiconductor device further comprises a further discrete p-doped region that is positioned on the Group III nitride barrier layer and below the gate electrode.

In some embodiments, the semiconductor device further comprises a field plate electrically coupled to the drain and the single p-doped region, the field plate being laterally spaced apart from the gate electrode.

In some embodiments, the barrier layer is a single layer having a uniform thickness between the source electrode and the drain electrode.

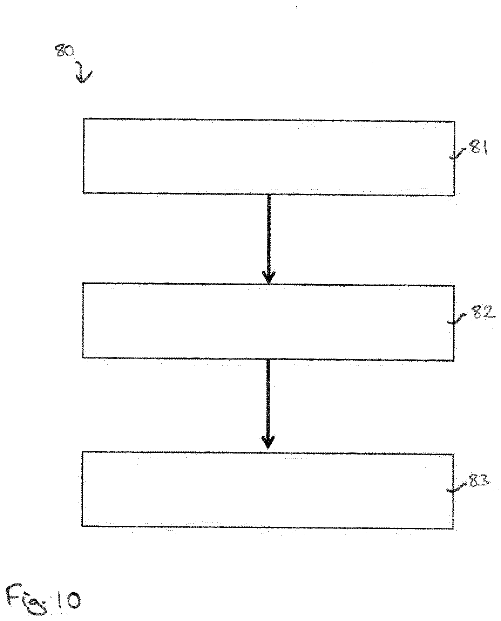

The semiconductor device according to any one of the embodiments described herein may be manufactured using the following method which is described in connection with the flowchart 80 of figure 10.

In block 81, a plurality of discrete p-doped regions are formed on a barrier layer of a Group III nitride-based transistor. The Group III nitride barrier layer is arranged on a Group III nitride channel layer. The Group III nitride barrier layer and the Group III nitride channel layer have differing bandgaps and form a heterojunction capable of supporting a two dimensional electron gas.

In block 82, a source electrode, a gate electrode and drain electrode are formed on the barrier layer, whereby the gate electrode is arranged between laterally between the source electrode and the drain electrode such that the plurality of discrete p-doped doped regions is arranged on a drain side of the gate electrode and laterally spaced apart from the gate electrode.

In block 83, the plurality of discrete p-doped regions is electrically coupled to the drain.

In some embodiments, the plurality of discrete p-doped regions is electrically coupled to the drain by forming the drain electrode on at least an edge region of the p-doped regions or by forming one or more additional electrical connectors between the drain electrode and each of the discrete p-doped regions. An additional electrical connector may be a bond wire, metallic ribbon or clip, or via, for example.

In some embodiments, the plurality of discrete p-doped regions is formed at the same time as gate p-doped region, the gate p-doped region being spaced apart from the plurality of discrete p-doped regions. A continuous p-doped layer may be deposited onto the Group III nitride layer and patterned to form the gate p-doped region and the discrete p-doped regions that are to be coupled to the drain electrode. Alternatively, the gate p-doped region and the discrete p-doped regions may be selectively deposited onto the Group III nitride barrier layer.

The source electrode, gate electrode and drain electrode may then be deposited, for example by depositing one or more metals, such that the gate electrode is positioned on the gate p-doped region and such that the stack of gate metal and gate p-doped region is positioned laterally between the source electrode and the drain electrode and such that the plurality of discrete p-doped regions are arranged on a drain side of the gate electrode and laterally spaced apart from the metal of the gate electrode as well as the gate p-doped region.

The Group III nitride channel layer may be gallium nitride and the Group III nitride barrier layer may be aluminium gallium nitride. The Group III nitride barrier layer may be arranged on a buffer structure which is in turn arranged on a support substrate, for example as illustrated in the cross-sectional views of figures 1, 2, 6, 7, 8 and 9.

In an embodiment, a single p-doped region is formed on a barrier layer of a Group III nitride-based transistor, the Group III nitride barrier layer being arranged on a Group III nitride channel layer, the Group III nitride barrier layer and the Group III nitride channel layer having differing bandgaps and forming a heterojunction capable of supporting a two dimensional electron gas, forming a source electrode, a gate electrode and a drain electrode on the barrier layer, the gate electrode being arranged between the source electrode and the drain electrode and the single p-doped region being arranged such that the drain electrode is arranged laterally between the p-doped region and a drain side of the gate electrode. The single p-doped region is electrically coupled the to the drain electrode.

In some embodiments, electrically coupling the single p-doped region to the drain electrode comprises forming the drain electrode on at least an edge region of the single p-doped region, or forming one or more additional electrical connectors between the drain electrode and the single p-doped region. Without being bound by theory, the functions of the discrete p-doped regions will now be described with reference to figure 10.

An issue in the GaN HEMT technology is the existence of deep traps which can lead to unwanted dynamic effects such as current collapse and dynamic RDSON increase at fast switching. In a single barrier GaN HEMT device with a pGaN gate structure, such as that illustrated in Figure 1, the threshold voltage and the drift resistance between gate and drain is controlled by the single AlGaN barrier.

An alternative GaN HEMT structure includes thick AlGaN Barrier and a thin AlGaN barrier. These structures are also referred to as dual barrier or recessed gate structures. With such a structure, the threshold voltage below the gate and the resistance of the drift region between the gate and drain contact can be independently controlled. For dual barrier structures, one way of mitigating these unwanted dynamic effects is to provide a single pGaN region at the drain side, which extends along the entire length of the drain electrode and which is electrically coupled to the drain electrode. This structure is also referred to as a hybrid drain. The single pGaN region can act as a hole injector at elevated voltages and under hard switching conditions leading to a strong reduction of the dynamic RDSON effect. As the injected holes cancel charged traps which are responsible for dynamic RON effects, the injected holes also improving the Safe Operating Area (SOA) behavior of the device.

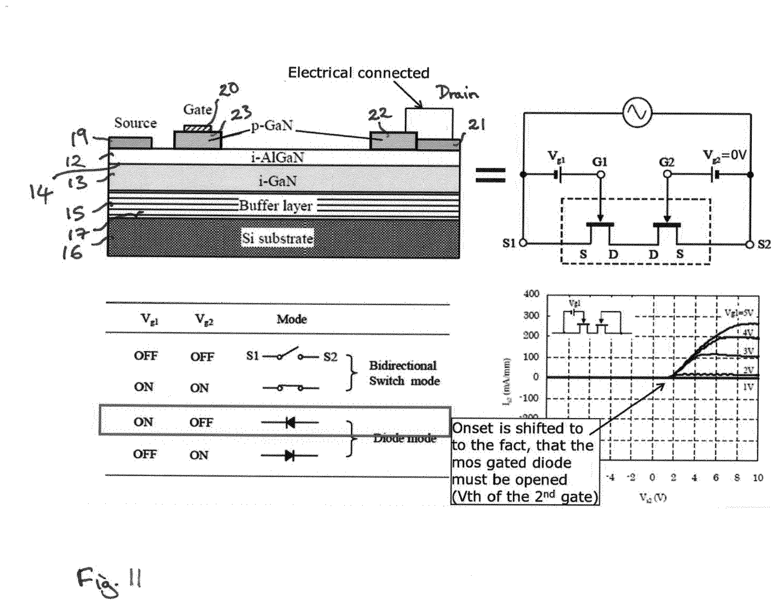

However, for a single barrier structure, such a dynamic RDSON improvement is not achievable, because a single barrier the pGaN at the drain side would lead to a pinch off channel at the drain side, which is not controlled by a gate. With a pGaN at the drain side the switching characteristic of such a device is shown in Figure 11. The device can turn on only if the drain voltage would exceed the threshold voltage of the gated pGaN region in a similar manner to a MOS-gated diode and shows similar behavior like a bidirectional GaN switch with two gates with the second gate connected to drain (S2).

However, a single barrier approach, such as that illustrated in the drawings, is very useful in terms of process costs and also for low voltage class devices, where a gate recess and the T-shape gate structure of the two barrier approach would lead to disadvantages in respect to gate-drain capacitance.

According to embodiments described herein, a disrupted pGaN hole injector at the drain is provided that includes a plurality of discrete p-doped regions rather than a continuous pGaN field plate or hybrid drain in order to allow a hole injection of a pGaN at the drain side. The drain voltage is high enough to turn on the transistor below the pGaN field plate also in hard switching conditions where the holes are needed to compensate the dynamic effects. The voltage drop along the pGaN field plate will allow the hole injection because the forward voltage of such a diode is achieved. With the disrupted pGaN field plate, the output characteristic has no onset as would be expected for a continuous pGaN field plate at the drain side.

Using the discrete p-doped regions at the drain side of the gate, a hole injector mechanism at the drain side of a GaN HEMT device is provided for a single barrier structure without lacking an onset in the output characteristics caused by the MOS-gated parasitic device below the pGaN hole injector. The drawbacks of the MOS-gated structure at low drain voltages can be suppressed and the required hole injection at hard switching is enabled. The device robustness is also improved for hard switching.

Spatially relative terms such as "under", "below", "lower", "over", "upper" and the like are used for ease of description to explain the positioning of one element relative to a second element. These terms are intended to encompass different orientations of the device in addition to different orientations than those depicted in the figures. Further, terms such as "first", "second", and the like, are also used to describe various elements, regions, sections, etc. and are also not intended to be limiting. Like terms refer to like elements throughout the description.

As used herein, the terms "having", "containing", "including", "comprising" and the like are open ended terms that indicate the presence of stated elements or features, but do not preclude additional elements or features. The articles "a", "an" and "the" are intended to include the plural as well as the singular, unless the context clearly indicates otherwise. It is to be understood that the features of the various embodiments described herein may be combined with each other, unless specifically noted otherwise.

Although specific embodiments have been illustrated and described herein, it will be appreciated by those of ordinary skill in the art that a variety of alternate and/or equivalent implementations may be substituted for the specific embodiments shown and described without departing from the scope of the present invention. This application is intended to cover any adaptations or variations of the specific embodiments discussed herein. Therefore, it is intended that this invention be limited only by the claims and the equivalents thereof.

## Claims

1. A semiconductor device, comprising:
a Group III nitride-based transistor comprising:
a Group III nitride channel layer,
a Group III nitride barrier layer on the Group III nitride channel layer, the Group III nitride barrier layer and the Group III nitride channel layer having differing bandgaps and forming a heterojunction capable of supporting a two dimensional electron gas, wherein the Group III nitride barrier layer has a major surface;
a source electrode, a gate electrode and a drain electrode arranged on the major surface of the Group III nitride barrier layer, the gate electrode being arranged between the source electrode and the drain electrode,
a plurality of discrete p-doped regions arranged on the major surface of the Group III nitride barrier layer and arranged on a drain side of the gate electrode and laterally spaced apart from the gate electrode, the plurality of discrete p-doped regions being electrically coupled to the drain electrode.

2. The semiconductor device of claim 1, wherein the Group III nitride barrier layer has a thickness such that the plurality of discrete p-doped regions produce a laterally localised depletion of the two dimensional electron gas below each of the plurality of discrete p-doped regions.

3. The semiconductor device of claim 1 or claim 2, wherein the plurality of discrete p-doped regions comprise a p-doped Group III nitride.

4. The semiconductor device of one of claims 1 to 3, wherein the plurality of discrete p-doped regions are arranged in a row extending substantially parallel to the drain electrode, the row being laterally arranged between the drain electrode and the gate electrode.

5. The semiconductor device of one of claims 1 to 4, wherein each of the discrete p-doped regions has a gate-facing end and a drain-facing end opposing the gate-facing end, wherein the gate-facing end has rounded corners, or is semi-circular or comprises a plurality of chamfers.

6. The semiconductor device of one of claims 1 to 5, wherein each discrete p-doped region has a length lᵢ and a spacing d from the nearest adjacent discrete p-doped region, wherein d ≤ lᵢ ≤ 1000d.

7. The semiconductor device of one of claims 1 to 6, wherein the drain comprises a plurality of sections arranged in a row and interleaved with the plurality of discrete p-doped regions.

8. The semiconductor device of one of claims 1 to 7, further comprising a field plate electrically coupled to the drain and the plurality of discrete p-doped regions, the field plate being laterally spaced apart from the gate electrode.

9. The semiconductor device of claim 8, wherein
the field plate partially covers the plurality of discrete p-doped regions leaving a portion of the discrete p-doped regions uncovered, or
the field plate entirely covers the plurality of p-discrete doped regions.

10. The semiconductor device of one of claims 1 to 9, wherein the barrier layer is a single layer having a uniform thickness between the source electrode and the drain electrode.

11. A semiconductor device, comprising:
a Group III nitride-based transistor comprising:
a Group III nitride channel layer,
a Group III nitride barrier layer on the Group III nitride channel layer, the Group III nitride barrier layer and the Group III nitride channel layer having differing bandgaps and forming a heterojunction capable of supporting a two dimensional electron gas, wherein the Group III nitride barrier layer has a major surface;
a source electrode, a gate electrode and a drain electrode arranged on the major surface of the Group III nitride barrier layer, the gate electrode being arranged between the source electrode and the drain electrode,
a single p-doped region arranged on the major surface of the Group III nitride barrier layer and electrically coupled to the drain electrode,
wherein the drain electrode is arranged laterally between the p-doped region and the gate electrode.

12. The semiconductor device of one of claims 1 to 11, wherein the drain electrode is in direct contact with the p-doped region, or is laterally spaced apart from the p-doped region.

13. The semiconductor device of one of claims 1 to 12, further comprising a further discrete p-doped region that is positioned on the Group III nitride barrier layer and below the gate electrode.

14. A method, comprising:
forming a plurality of discrete p-doped regions on a barrier layer of a Group III nitride-based transistor, the Group III nitride barrier layer being arranged on a Group III nitride channel layer, the Group III nitride barrier layer and the Group III nitride channel layer having differing bandgaps and forming a heterojunction capable of supporting a two dimensional electron gas;
forming a source electrode, a gate electrode and a drain electrode on the barrier layer, the gate electrode being arranged between the source electrode and the drain electrode such that the plurality of discrete p-doped regions are arranged on a drain side of the gate electrode and laterally spaced apart from the gate electrode;
electrically coupling the plurality of discrete p-doped regions to the drain electrode.

15. The method of claim 14, wherein the electrically coupling the plurality of discrete p-doped regions to the drain electrode comprises:
forming the drain electrode on at least an edge region of the discrete p-doped regions, or
forming one or more additional electrical connectors between the drain electrode and each of the discrete p-doped regions.
